# EUROPEAN PATENT APPLICATION

(11) **EP 2 369 748 A1**
(43) Date of publication of application: **28.09.2011**
(21) Application number: 11157805.0
(22) Date of filing: 11.03.2011
(51) Int. Cl.: H03M 7/30

(54) **Dynamically configurable sensor chassis**

(30) Priority: 22.03.2010 US 713361
(71) Applicant: General Electric Company, Schenectady, NY 12345 (US)
(72) Inventor: Hershey, John Erik, Niskayuna, NY 12309 (US); Hartman, Michael James, Niskayuna, NY 12309 (US); Zinser, Richard Louis, Niskayuna, NY 12309 (US); Ross, John Anderson Fergus, Niskayuna, NY 12309 (US)
(74) Representative: Bedford, Grant Richard

(57) **Abstract**

A method and a system (100, 200) for configuring a sensor chassis (102) are presented. In the presented method, a set of parameters may be remotely received by the sensor chassis (102) for compressively sampling an input signal. Further, a compressive sampling protocol for compressively sampling the input signal may be dynamically determined based on the remotely received set of parameters. Particularly, the compressive sampling protocol may be dynamically determined for achieving a desired sampling performance. Subsequently, the input signal is compressively sampled according to the determined compressive sampling protocol.

## Description

Various embodiments of the present technique relate generally to sampling techniques, and more particularly to a system and method for compressively sampling a signal of interest.

Success of digital data acquisition processes has placed enormous pressure on signal processing hardware and software to support higher resolutions, denser sampling, a large number of sensors and an even larger number of modalities. Conventionally, digital data acquisition processes employ the Nyquist-Shannon sampling theorem that provides uniform sampling of data at the Nyquist rate, that is, at twice the bandwidth. However, most signals are sparse and contain several coefficients close to or equal to zero when represented in a linear transform domain, such as, frequency, wavelet or time. Therefore, sampling these sparse signals at the Nyquist rate, which is a worst-case threshold for any band-limited data, results in oversampling of the signal. This oversampling may further result in unnecessary computation, storage and battery requirements, thereby severely limiting the capabilities and performance of digital devices such as cameras, microarrays and wireless sensor networks.

Compressive sensing (CS) is an emerging field that provides a framework for efficient sampling of sparse signals using sub-Nyquist sampling rates. By employing CS, a sparse signal can be perfectly reconstructed, or robustly approximated, from a small set of random projections even in the presence of noise with sub-Nyquist sampling rates. Particularly, CS exploits *a priori* signal sparsity information for estimating signals in the presence of noise and solving signal restoration and imaging problems. Moreover, each compressively sampled measurement may include substantially the same amount of information, thereby simplifying the encoding and quantization processes.

Compressive sensing, therefore, has been applied in a variety of technology areas such as inventory management, homeland security, healthcare, Magnetic Resonance Imaging (MRI), and geo-sensing applications. Most CS systems, however, are customized for specific application requirements with each CS component being custom built to perform a specific set of functions. Such customization burdens the available space, power and computational resources of devices using multiple sensors that sample multiple signals for implementing feature-rich applications. Moreover, use of these customized components limit scalability and adaptability of the CS systems. Additionally, such configurations fail to allow updates to existing functions or dynamic mitigation of detected software and hardware errors.

It may therefore be desirable to develop a generic sampling technique for compressively sampling a plurality of signals even in the absence of prior knowledge or assumptions about the signals and corresponding applications. Particularly, there is a need for an adaptive system and method for dynamically configuring CS protocols based on a specified set of parameters for implementing desired functions and achieving a desired sampling performance.

In accordance with certain aspects of the present technique, a method for configuring a sensor chassis is presented. The method includes remotely receiving a set of parameters for compressively sampling an input signal. Further, a CS protocol for compressively sampling the input signal may be dynamically determined based on the remotely received set of parameters for achieving a desired sampling performance. Subsequently, the input signal is compressively sampled according to the determined CS protocol.

In accordance with a further aspect of the present technique, a sensor chassis is disclosed. The sensor chassis includes a receiver that receives an input signal and a processing subsystem that remotely receives a set of parameters for compressively sampling the input signal. Further, the processing subsystem may dynamically determine a CS protocol for compressively sampling the input signal based on the remotely received set of parameters for achieving a desired sampling performance. To that end, the sensor chassis may include one or more programmable filters, where each programmable filter has at least one setting whose value may be adjusted according to the determined CS protocol. Subsequently, the sensor chassis compressively samples the input signal according to the determined CS protocol. Various features, aspects, and advantages of the present technique will become better understood when the following detailed description is read with reference to the accompanying drawings in which like characters represent like parts throughout the drawings, wherein:
FIG. 1 is a block diagram of an exemplary environment for a system that facilitates dynamic configuration of a sensor chassis, in accordance with aspects of the present technique;
FIG. 2 is a block diagram of a sensor chassis that dynamically determines a CS protocol for compressively sampling an input signal, in accordance with aspects of the present technique;
FIG. 3 is a flow chart illustrating an exemplary method for dynamically configuring a sensor chassis, in accordance with aspects of the present technique;
FIG. 4 is a graphical representation of a plurality of input signal characteristics; and
FIG. 5 is a flow chart illustrating another exemplary method for compressively sampling an input signal, in accordance with aspects of the present technique.

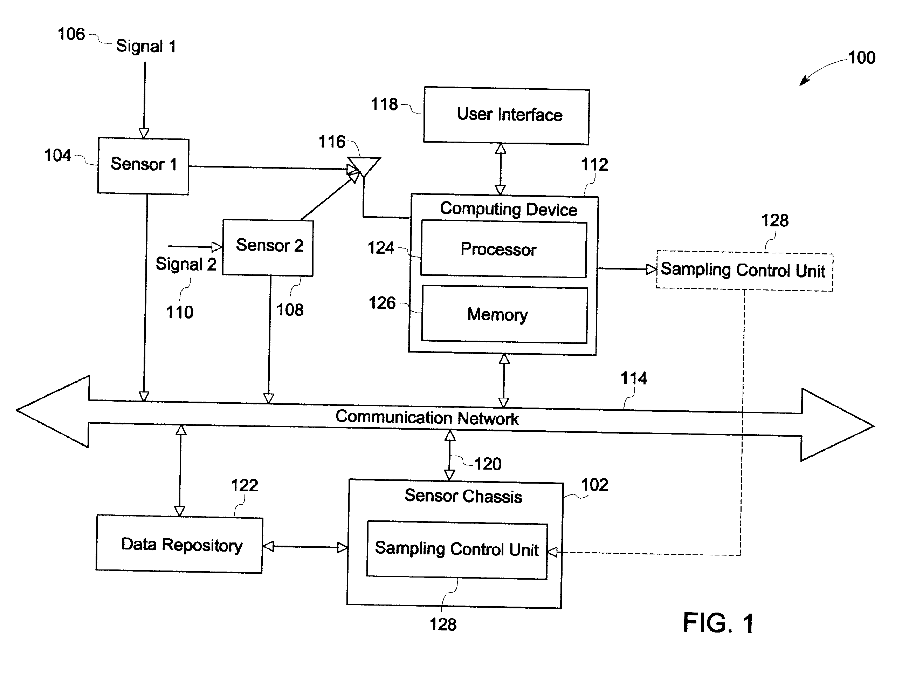

The following description presents a technique for dynamically configuring a sensor chassis for compressively sampling an input signal. Particularly, embodiments illustrated hereinafter describe a sensor chassis and a method for dynamically configuring the sensor chassis to compressively sample the input signal based on one or more received parameters. Although the following description includes only a few embodiments, the present technique may be implemented in many different operating environments and systems for compressively sampling a plurality of signals of interest. By way of example, the present technique may be used in environment monitoring, inventory management, homeland security, healthcare, Magnetic Resonance Imaging (MRI), and wireless sensing applications. An exemplary environment that is suitable for practising various implementations of the present technique will be discussed in the following sections with reference to FIG. 1.

FIG. 1 illustrates an exemplary environment 100 that facilitates dynamic configuration of a sensor chassis 102, in accordance with aspects of the present technique. For clarity, an exemplary implementation of the present technique will be described in the context of monitoring the environment 100 for evaluating emergency situations. In one embodiment, the environment 100 may include a first sensor 104 for sensing a first input signal 106, such as a radio frequency (RF) signal, traversing a particular region in the environment 100. The environment 100 may further include a second sensor 108 for monitoring a second signal 110. The second signal 110 may include a spatially varying phenomenon such as temperature, light or moisture in the particular region traversed by the first input signal 106. For purposes of discussion, however, the present technique will be described with reference to the dynamic configuration of the sensor chassis 102 for compressively sampling the first input signal 106. Further, it may be appreciated that although FIG. 1 illustrates two sensors, fewer or more sensors may be deployed to sense fewer or more signals and a corresponding set of parameters in the environment 100 as per application or user requirements. In one embodiment, the set of parameters may include an environmental datum associated with the first input signal 106, a characteristic of the first input signal 106, and so on. By way of example, the environmental datum may include at least one of an ambient noise bandwidth, an ambient noise duty cycle, an ambient noise power spectral density, an ambient noise average power and an ambient noise peak power. Further, the input signal characteristic may include at least one of the input signal bandwidth, the input signal duty cycle, the input signal power spectral density, the input signal average power and the input signal peak power.

Additionally, the set of parameters may also include a parameter corresponding to the sensor chassis 102 (sensor chassis parameter) and a criterion specifying the desired sampling performance. By way of example, the sensor chassis parameter may include a type of analog-to-digital converter (ADC) to be used, a sampling rate, a desired number of bits per sample, or combinations thereof. Moreover, the desired sampling performance may correspond to a maximum acceptable difference between the first input signal 106 and a signal reconstructed according to the determined CS protocol. As used herein, the term "maximum acceptable difference" is defined as a reconstruction not differing from the first input signal 106 by more than a determined amount in a voltage or a power domain.

In accordance with aspects of the present technique, the set of parameters may be transmitted to a computing device 112 communicatively coupled to the sensors 104 and 108 over a communication network 114. The communication network 114 may include either or both of wired networks such as LAN and cable, and wireless networks such as WLAN, cellular networks, and/or satellite networks. Particularly, the set of parameters may be remotely received by the computing device 112 over the communication network 114. These parameters may generally be referred to as a remotely received set of parameters. As used herein, the term "remotely received set of parameters" refers to the set of parameters that may be indirectly received by the computing device 112 through a receiver 116 operatively coupled to at least one of the sensors 104 and 108, a user interface 118, a digital communication link 120 or a data repository 122 coupled to the computing device 112 over the communication network 114. In certain embodiments, however, the term "remotely received set of parameters" refers to the set of parameters that may be indirectly received by the sensor chassis 102 through the receiver 116 operatively coupled to at least one of the sensors 104 and 108, the user interface 118, the digital communication link 120 or the data repository 122 over the communication network 114.

Further, in accordance with aspects of the present technique, the computing device 112 may evaluate the remotely received set of parameters to determine one or more characteristics corresponding to the first input signal 106 and desired application and/or user requirements. For example, in case of a fire that originates in the particular region, one or more obstructions may block certain paths to an exit. The computing device 112 may evaluate the set of parameters received during a particular time interval from the sensors 104 and 108 positioned in and around the particular region. Particularly, the computing device 112 may evaluate a change in temperature that may be detected by the second sensor 108 to efficiently locate the fire. Additionally, the computing device 112 may also evaluate a change in determined positions of one or more objects in the particular region detected by the first sensor 104 to ascertain if objects have moved to create obstructions to the exit. The evaluation, thus, may allow security personnel to locate and evacuate people quickly and efficiently. To that end, the computing device 112 may include a processor 124 and a memory 126 for evaluating the received set of parameters. By way of example, the processor 124 may include one or more microprocessors, microcomputers, microcontrollers, dual core processors, and so forth. The processor 124 may dynamically determine a CS protocol for compressively sampling the first input signal 106 based on the remotely received set of parameters. Particularly, the processor 124 may evaluate the set of parameters to determine the CS protocol that may be used by the sensor chassis 102 to compressively sample the first input signal 106 to achieve the desired sampling performance.

In accordance with a further aspect of the present technique, the processor 124 may store one or more instructions corresponding to the determined CS protocol on a storage device coupled to the computing device 112. In a presently contemplated configuration, the processor 124 may store the one or more instructions corresponding to the determined CS protocol on a sampling control unit 128. In such a configuration the sampling control unit 128 may be an independent unit physically removed from the computing device 112 and/or the sensor chassis 102. In one embodiment, the independent sampling control unit 128 may initially be communicatively coupled to the computing device 112 for facilitating the processor 124 to program and store the one or more instructions on the sampling control unit 128. Subsequently, the sampling control unit 128, thus programmed by the processor 124, may be communicatively coupled to the sensor chassis 102 for compressively sampling the first input signal 106 based on the determined CS protocol. In accordance with aspects of the present technique, the sampling control unit 128 may include at least one of a memory device, a programmable device, and/or instructions received through a control device operatively coupled to the sensor chassis 102. Particularly, in one implementation, the sampling control unit 128 may include a field programmable gate array (FPGA). The FPGA implementation may allow dynamic configuration of multiple CS protocols, thus providing immense scalability and adaptability to the sensor chassis 102. Alternatively, the sampling control unit 128 may be implemented as an optical disk, a tape, a compact disk, and so on. The exemplary implementation, thus, may enable fabrication of a generic sensor chassis that may be configured 'on the fly' to dynamically select an appropriate CS protocol for sampling any received input signal. Such a generic sensor chassis may reduce the time and complexity involved in manufacturing and operating the sensor chassis. Additionally, the generic sensor chassis may also facilitate sampling of a plurality of input signals based on the structure of the input signals and ambient conditions.

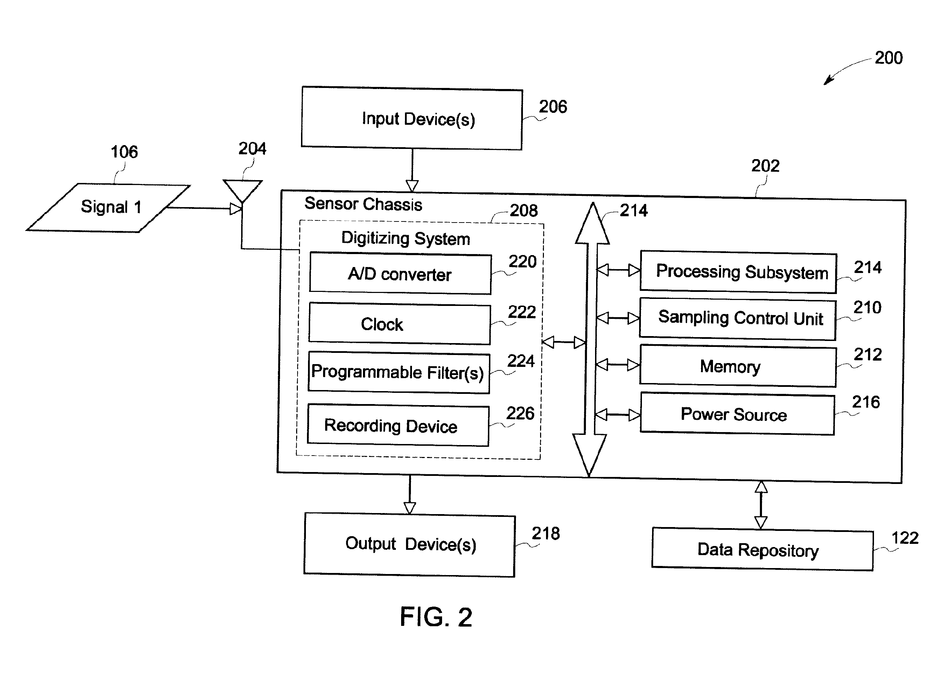

Turning to FIG. 2, a block diagram 200 of one embodiment of a sensor chassis 202 that dynamically determines a CS protocol for compressively sampling an input signal is presented. To that end, the sensor chassis 202 may include a receiver 204 and one or more input devices 206 such as a user interface, a keyboard, and so on to receive the input signal such as the first input signal 106 of FIG. 1 and a corresponding set of parameters. Particularly, in the present embodiment, the sensor chassis 202 may remotely receive the input signal 106 and the corresponding set of parameters from at least one of the set of sensors 104 and 108 of FIG. 1, a user interface coupled to the input device 206, the digital communication link 120 of FIG. 1 or the data repository 122 of FIG. 1. Accordingly, the set of sensors 104 and 108, the user interface, the digital communication link 120 and the data repository 122 may be communicatively coupled to the sensor chassis 202. The sensor chassis 202 may further include a digitizing system 208, a sampling control unit 210, and memory 212 coupled to a processing subsystem 214 for sampling the received input signal 106. In the embodiment illustrated in FIG. 2, the sampling control unit 210 may have one or more structural and/or functional similarities with the sampling control unit 128 of FIG. 1. In the embodiment illustrated in FIG. 2, however, the sampling control unit 210may be an integral part of the sensor chassis 202 and may not be an independent unit like the sampling control unit 128.

In accordance with aspects of the present technique, the processing subsystem 214 may use one or more parameters corresponding to the sampled input signal 106 to monitor the sampling performance of the sensor chassis 202. In case the desired sampling performance is not achieved, the sensor chassis 202 may provide an alert through an output device 218 coupled to the sensor chassis 202. Subsequently, in certain embodiments, the processing subsystem 214 may further customize the determined CS protocol to achieve the desired sampling performance upon receiving the alert through the output device 218. By way of example, the output device 218 may include visual indicators such as a display and blinking lights, audio indicators such as speakers, and so on. Additionally, the sensor chassis 202 may include a power source 216 for operating the sensor chassis 202. The power source 216 may include a battery, line power, solar or wind powered cells, and so on to suit desired application and deployment needs. By way of example, in an air sampling system, the sensor chassis 202 may use a solar powered cell as the power source 216, whereas in a deep-sea sampling system a lead-acid battery may be used as the power source 216.

Thus, the sensor chassis 202 may provide a generic platform that may be dynamically configured to compressively sample a plurality of input signals without requiring any prior knowledge about the input signal or the desired application. Accordingly, the generic nature of the sensor chassis 202 may greatly reduce manufacturing time and complexity. Additionally, the dynamic configuration capability may also enable implementation of a variety of applications using the same sensor chassis 202, thereby reducing deployment costs and efforts. Accordingly, the processing subsystem 214 may analyze the input signal 106 and the corresponding set of parameters to dynamically determine an appropriate CS protocol to achieve the desired sampling performance. Subsequently, the digitizing system 208 may use the determined CS protocol to compressively sample, record and reconstruct the input signal 106. To that end, the digitizing system 208 may include an ADC 220, a clock 222, at least one programmable filter 224 and a recording device 226 for sampling and recording the input signal 106. Therefore, in the present embodiment, the sensor chassis 202 may be equipped to implement a variety of applications without requiring any additional processing devices such as the computing device 112 of FIG. 1.

In certain embodiments, the processing subsystem 214 may precondition the input signal 106 to accurately capture salient information corresponding to the input signal 106. By way of example, the salient information may include one or more characteristics corresponding to the input signal 106 such as an input signal structure, an input signal bandwidth, an input signal peak power, and so on. The processing subsystem 214 may use the salient information to introduce sensing diversity to provide a distinct signature or fingerprint to the input signal 106. Moreover, the processing subsystem 214 may analyze the corresponding set of parameters to determine an environmental datum such as ambient noise and sensor chassis characteristics. Particularly, the processing subsystem 214 may evaluate sensor chassis characteristics such as a sampling rate of the ADC 220 and/or a desired sampling performance criterion to determine a CS protocol for sampling the input signal 106 efficiently. In one embodiment, the processing subsystem 214 may query the data repository 122 coupled to the sensor chassis 202 to determine an appropriate CS protocol for compressively sampling the input signal 106. To that end, the data repository 122 may include a plurality of CS protocols devised for different input signals using conventional techniques, such as a distilled sensing technique for astronomical imaging, a non convex compressed sensing for non-Gaussian noise, and so on. Therefore, in accordance with aspects of the present technique, the processing subsystem 214 may query the data repository 122 to determine the CS protocol based on a previously stored correlation, if any, corresponding to the input signal 106 and a CS protocol previously used to compressively sample the input signal 106. In one embodiment, the processing subsystem 214 may select the CS protocol corresponding to the stored correlation to compressively sample the input signal 106. In certain other embodiments, the processing subsystem 214 may further customize the selected CS protocol in accordance with application or user requirements to achieve the desired sampling performance.

Further, the processing subsystem 214 may communicate one or more instructions corresponding to the determined CS protocol to the sampling control unit 210. Subsequently, the sampling control unit 210 may adjust one or more settings corresponding to the programmable filter 224 based on the determined CS protocol to achieve the desired sampling performance. The one or more settings, for example, may correspond to selection of a desired bandwidth to filter out noise, a desired sampling rate, a duty cycle of the input signal 106, a desired sampling accuracy, a number of bits per sample, and so on.

The configuration of the programmable filter 224 may enable the sensor chassis 202 to compressively sample the input signal 106 according to the determined CS protocol. Accordingly, the sensor chassis 202 may employ the ADC 220 and the clock 222 for converting the analog input signal 106 to a sequence of quantized, periodic discrete-time samples. Subsequently, the recording device 226 may record the sampled input signal 106, which may be then be reconstructed by the processing subsystem 214.

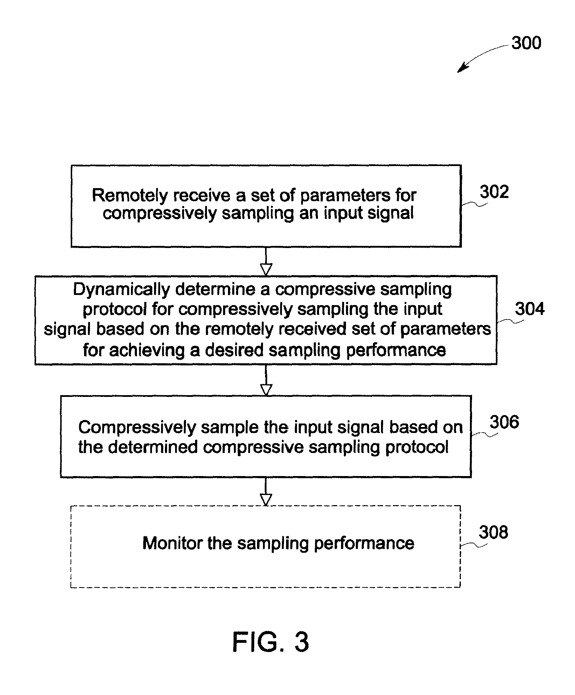

Turning to FIG. 3, a flowchart 300 depicting an exemplary method for configuring a sensor chassis, such as the sensor chassis 102 of FIG. 1 or the sensor chassis 202 of FIG. 2 is illustrated. The method may be described in a general context of computer executable instructions that may be located in either or both of local and remote computer storage media, such as memory storage devices. Further, in FIG. 3, the method is illustrated as a collection of blocks in a logical flow graph, which represents a sequence of operations that may be implemented in hardware, software, or combinations thereof. The various operations are depicted in the blocks to illustrate the functions that are performed generally during remotely receiving a set of parameters, determination of a CS protocol, and compressive sampling phases. In the context of software, the blocks represent computer instructions that, when executed by one or more processors, perform the recited operations. The order in which the method is described is not intended to be construed as a limitation, and any number of the described blocks may be combined in any order to implement the method disclosed herein, or an equivalent alternative method. Additionally, individual blocks may be deleted from the method without departing from the spirit and scope of the subject matter described herein.

Determination of a CS protocol generally entails use of salient information such as a set of parameters corresponding to an input signal. As used herein, the term "set of parameters" may refer to a collection of one or more parameters corresponding to the input signal, such as the input signal 106 of FIG. 1. In accordance with aspects of the present technique, the set of parameters may include an environmental datum associated with the input signal, a characteristic of the input signal, a parameter corresponding to the sensor chassis, and a criterion specifying a desired sampling performance. The method begins at step 302 with the sensor chassis remotely receiving the set of parameters for compressively sampling the input signal. In one embodiment, the sensor chassis may remotely receive the set of parameters from a user interface, a data repository, a set of sensors, a digital communication link, or combinations thereof. To that end, the user interface, the data repository, the set of sensors and/or the digital communication link may be communicatively coupled to the sensor chassis. By way of example, an operator may input the environmental datum, the input signal characteristic, the sensor chassis parameter or the desired sampling performance criterion through a user interface. Alternatively, the sensor chassis may receive some or all of the parameters from the set of sensors over a communication network such as the communication network 114 of FIG. 1.

Subsequently, at step 304, the sensor chassis may dynamically determine a CS protocol for compressively sampling the input signal based on the remotely received set of parameters for achieving a desired sampling performance. As previously noted, a processing subsystem, such as the processing subsystem 214 of FIG. 2, may be employed to dynamically determine a CS protocol by evaluating the received set of parameters. By way of example, the processing subsystem 214 may analyze the received environmental datum to evaluate the effect of ambient environment on the desired sampling performance. As previously noted, the processing subsystem 214 may evaluate specified values corresponding to the environmental datum such as an ambient noise bandwidth and/or an ambient noise duty cycle while determining an appropriate CS protocol for compressively sampling the first input signal 106. Similarly, the processing subsystem 214 may also consider the sensor chassis parameter that specifies at least one of a type of ADC to be used, a sampling rate, and a number of bits per sample to determine the CS protocol. By way of example, in one implementation, the sensor chassis may include a 24-bit ADC, such as the ADC 220 of FIG. 2, whereas the desired sampling performance may mandate a precision of only 12 bits. Accordingly, the determined CS protocol may vary one or more values corresponding to an appropriate programmable filter in the sensor chassis to use only the first 12 bits of the 24 bits corresponding to the ADC.

In accordance with aspects of the present technique, the processing subsystem may further customize the determined CS protocol to achieve the desired sampling performance. As previously noted, the desired sampling performance may correspond to a maximum acceptable difference between the input signal and a signal reconstructed according to the determined CS protocol. By way of example, in an image compression application, the processing subsystem may determine the CS protocol that not only considers image structure and intra-image correlations, but also adheres to specified error limits during image reconstruction.

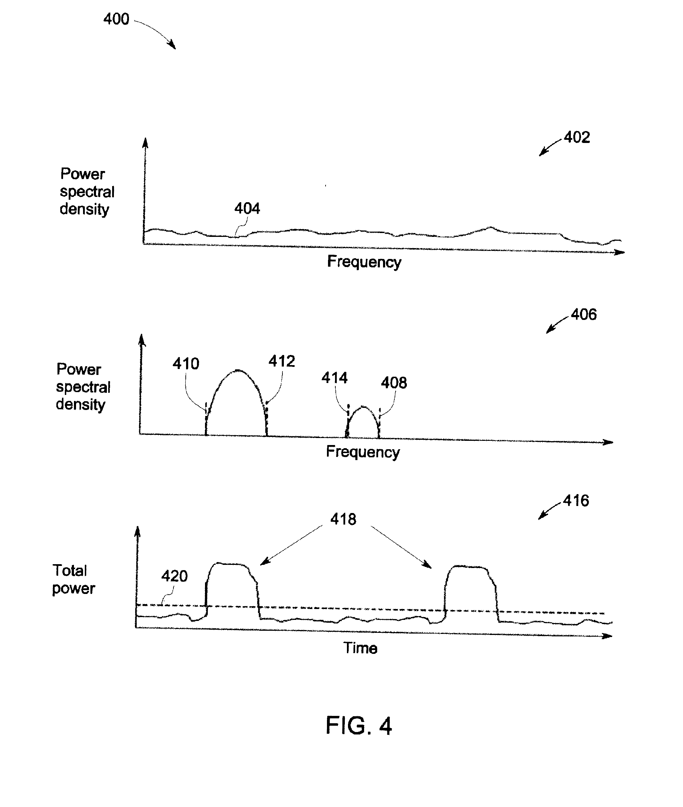

Further, in accordance with aspects of the present technique, the processing subsystem may determine the CS protocol to efficiently exploit the structure and other input signal characteristics such as the input signal power spectral density, the input signal average power, and so on. An exemplary implementation of how the processing subsystem may determine the appropriate CS protocol for compressively sampling the input signal will be discussed in greater detail with reference to FIG. 4.

FIG. 4 illustrates a graphical representation 400 of a plurality of input signal characteristics corresponding to an input signal, such as the input signal 106 of FIG. 1. Graph 402 depicts a power spectral density trace 404 in the absence of any input signal. Accordingly, the sensor chassis assumes the depicted power spectrum to be noise, such as, ambient environmental noise or receiver system noise. Further, graph 406 illustrates a power spectral density corresponding to the input signal. The power spectral density plot may provide one or more signal characteristics that may be exploited while determining the CS protocol for sampling the input signal. For example, the graph 406 indicates absence of any input signal energy above a frequency denoted by reference numeral 408. A receiver front end may be programmed accordingly to provide for a sharp cut-off above this frequency. Similarly, the graph 406 also indicates absence of any appreciable input signal energy below a frequency denoted by reference numeral 410. Additionally, graph 406 indicates absence of any appreciable input signal energy between frequencies identified by reference numeral 412 and reference numeral 414. The sensor chassis may use these signal characteristics to determine a CS protocol that may enable configuration of appropriate settings corresponding to one or more band pass filters, such as the programmable filter 224 of FIG. 2.

In a similar manner, graph 416 is a representation of a total power received at a front end of a receiver, such as the receiver 204, coupled to the sensor chassis. The total power at an instant of time may be defined as a sum of the power spectral density over all frequencies at that instant. The graph 416 indicates that an input signal 418 is only present intermittently over the illustrated period of time. Therefore, while determining the CS protocol, a threshold 420 on the total power may be specified such that compressive sampling may be enabled only when the total power equals or exceeds the threshold 420. Moreover, the depicted input signal characteristics may serve as identifiers of a signal class. Particularly, the input signal characteristics may identify the signal class corresponding to the input signal. Accordingly, in one embodiment, the sensor chassis may query a signal library stored in a data repository coupled to the sensor chassis based on the identified input signal class to determine an appropriate CS protocol for sampling the input signal. As previously noted, the data repository such as the data repository 122 of FIG. 2 may include previously stored correlations between input signal classes and CS protocols previously used to compressively sample the corresponding input signals. Such an implementation may greatly reduce processing time and effort required for determining appropriate CS protocols for compressively sampling a plurality of input signals.

With returning reference to FIG. 3, at step 306, the input signal may be compressively sampled by employing the CS protocol dynamically determined at step 304 of FIG. 3. Further, at step 308, the sensor chassis may optionally monitor a sampling performance of the sensor chassis to verify if the CS protocol yields reconstructed signals in accordance with the desired sampling performance. In addition, the sensor chassis may provide a visual an/or an audio alert through an output device, such as the output device 218 of FIG. 2 upon determining that the desired sampling performance is not achieved. Alternatively, based on desired application requirements, the sensor chassis may provide an alert upon determining that the desired sampling performance is achieved.

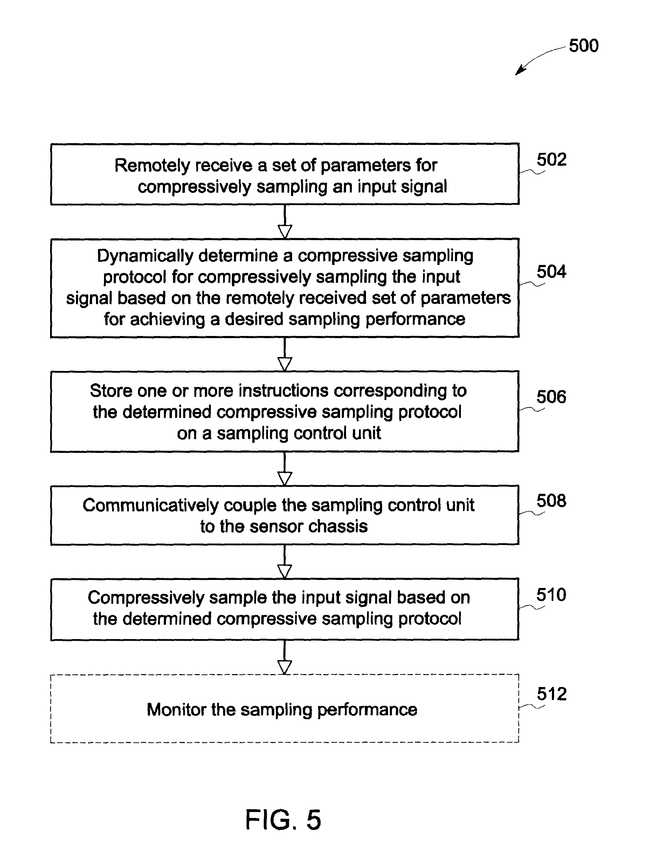

The exemplary method, therefore, describes a technique for dynamically configuring the sensor chassis to compressively sample input signals even where prior information corresponding to the input signals or a desired application is not available. The present technique, thus, allows for fabrication of a generic sensor chassis that may be dynamically configured to implement changing application requirements, thereby reducing the time and complexity involved in setting up and operating CS systems. In accordance with further aspects of the present technique, an alternative embodiment of the exemplary method for compressively sampling the input signal by using a portable sampling control unit is presented and will be discussed in greater detail with reference to FIG. 5.

FIG. 5 illustrates a flowchart 500 depicting an alternative method for compressively sampling an input signal using a portable sampling control unit, such as the sampling control unit 128 of FIG. 1. The flowchart 500 corresponds to the description of FIG. 1, where the sampling control unit 128 is available as an independent unit that may be programmed and subsequently coupled to the sensor chassis to facilitate compressive sampling of the input signal. It may be noted that one or more steps of the flowchart 500 may correspond to one or more steps of the flowchart 300 described with reference to FIG. 3. Therefore, such steps may not be discussed in detail in the ensuing description of the flowchart 500.

As previously described with reference to the step 302 of FIG. 3, at step 502, the sensor chassis may remotely receive a set of parameters for compressively sampling the input signal. Further, at step 504, the sensor chassis may dynamically determine a CS protocol for compressively sampling the input signal based on the remotely received parameters. Particularly, the sensor chassis may evaluate the set of parameters to dynamically select or customize the CS protocol such that a desired sampling performance is achieved, as described with reference to step 304 of FIG. 3.

Subsequently, at step 506, the sampling control unit may be programmed to store one or more instructions corresponding to the determined CS protocol. In accordance with aspects of the present technique, the sampling control unit may be an independent unit such as the sampling control unit 128 described with reference to FIG. 1. Further, as previously noted, the sampling control unit may include at least one of a memory device, a programmable device, a control device, and a digital control link. By way of example, the sampling control unit may include an FPGA, an optical disk, a tape, a compact disk, and so on. Once the one or more instructions are stored, the sampling control unit may then be communicatively coupled to the sensor chassis for appropriately varying values of one or more settings corresponding to a plurality of programmable filters, as indicated by step 508. Particularly, the sampling control unit may vary the one or more settings based on the determined CS protocol to achieve the desired sampling performance.

Thus, in accordance with aspects of the present technique, a generic sensor chassis deployed in a field may remotely receive or detect a set of parameters representative of the input signal to be sampled. An appropriate CS protocol may be determined for sampling the input signal based on the remotely received set of parameters that may include application and user requirements. Instructions corresponding to the determined CS protocol may be stored on a sampling control unit. Subsequently, the sampling control unit having the stored instructions may be installed in the generic sensor chassis. The sampling control unit may, thus, facilitate the generic sensor chassis to compressively sample the input signal according to the determined CS protocol to achieve the desired sampling performance as indicated by step 510. Further, as previously described with reference to step 308 of FIG. 3, at step 512, the sampling control unit may optionally provide instructions to the sensor chassis for monitoring a sampling performance of the sensor chassis. Particularly, the sensor chassis may verify if the determined CS protocol yields reconstructed signals in accordance with the desired sampling performance based on the instructions received from the sampling control unit. Additionally, the sampling control unit may direct the sensor chassis to provide an alert through an output device coupled to the sensor chassis upon determining that the desired sampling performance is not achieved. Thus, the ability of the sampling control unit to be programmed independently and later disposed in a generic sensor chassis to implement desired functions imparts a great amount of portability to a sensor chassis implementation.

The exemplary system and method described hereinabove, thus, enable dynamic configuration of multiple CS protocols to sample a plurality of input signals based on the structure of the input signal, ambient conditions and application and user requirements. The dynamic configuration capability allows quick adaptation to changing application requirements without requiring additional or new hardware, thereby conserving space and battery power. Moreover, the dynamic configuration also allows correction or mitigation of programming errors that may be detected after deployment of the sensor chassis. More particularly, the exemplary method enables fabrication of a generic sensor chassis that may be deployed anywhere and configured 'on the fly' to sample a plurality of input signals for a variety of different applications.

While only certain features of the present invention have been illustrated and described herein, many modifications and changes will occur to those skilled in the art. It is, therefore, to be understood that the appended claims are intended to cover all such modifications and changes as fall within the true spirit of the invention.

Various aspects and embodiments of the present invention are defined by the following numbered clauses:
1. A method for configuring a sensor chassis, comprising:
   remotely receiving a set of parameters for compressively sampling an input signal;
   dynamically determining a compressive sampling protocol for compressively sampling the input signal based on the remotely received set of parameters for achieving a desired sampling performance; and
   compressively sampling the input signal according to the determined compressive sampling protocol.
2. The method of clause 1, wherein the received set of parameters comprises an environmental datum associated with the input signal, a characteristic of the input signal, a parameter corresponding to the sensor chassis, and a criterion specifying the desired sampling performance.
3. The method of any preceding clause, wherein the environmental datum associated with the input signal specifies at least one of an ambient noise bandwidth, an ambient noise duty cycle, an ambient noise power spectral density, an ambient noise average power, and an ambient noise peak power.
4. The method of any preceding clause, wherein the characteristic of the input signal specifies at least one of an input signal bandwidth, an input signal duty cycle, an input signal power spectral density, an input signal average power, and an input signal peak power.
5. The method of any preceding clause, wherein the parameter corresponding to the sensor chassis specifies at least one of a type of an analog-to-digital converter to be used, a sampling rate, and a number of bits per sample.
6. The method of any preceding clause, wherein the criterion specifying the desired sampling performance is a maximum acceptable difference between the input signal and a signal reconstructed according to the determined compressive sampling protocol.
7. The method of any preceding clause, wherein remotely receiving the set of parameters comprises receiving the set of parameters from at least one of a user interface, a data repository, a set of sensors, and a network communication link, wherein the user interface, the data repository, the set of sensors and the network communication link are communicatively coupled to the sensor chassis.
8. The method of any preceding clause, wherein compressively sampling the input signal according to the determined compressive sampling protocol comprises:
   storing one or more instructions corresponding to the determined compressive sampling protocol on a sampling control unit; and
   communicatively coupling the sampling control unit to the sensor chassis.
9. The method of any preceding clause, wherein the sampling control unit comprises at least one of a memory device, a programmable device, and a control device.
10. The method of any preceding clause, further comprising:
   monitoring a sampling performance of the sensor chassis; and
   alerting if the desired sampling performance is not achieved.
11. The method of any preceding clause, further comprising customizing the determined compressive sampling protocol upon determining that the desired sampling performance is not achieved.
12. A sensor chassis, comprising:
   a receiver that receives an input signal;
   a processing subsystem that:
      remotely receives a set of parameters for compressively sampling the input signal;
      dynamically determines a compressive sampling protocol for compressively sampling the input signal based on the remotely received set of parameters for achieving a desired sampling performance; and
      one or more programmable filters, each programmable filter having at least one setting, wherein a value corresponding to each of the at least one setting is adjusted according to the determined compressive sampling protocol,
      wherein the sensor chassis compressively samples the input signal according to the determined compressive sampling protocol.
13. The sensor chassis of any preceding clause, wherein the processing subsystem remotely receives the set of parameters from at least one of a user interface, a data repository, a set of sensors, and a network communication link, wherein the user interface, the data repository, the set of sensors and the network communication link are communicatively coupled to the sensor chassis.
14. The sensor chassis of any preceding clause, further comprising a sampling control unit, wherein the sampling control unit receives one or more instructions corresponding to the determined compressive sampling protocol from the processing subsystem.
15. The sensor chassis of any preceding clause, wherein the sampling control unit comprises at least one of a memory device, a programmable device, and a control device.
16. The sensor chassis of any preceding clause, wherein the processing subsystem further:
   monitors a sampling performance of the sensor chassis; and
   generates an alert based on the monitored sampling performance.
17. The sensor chassis of any preceding clause, further comprising a data repository for storing a plurality of compressive sampling protocols.
18. The sensor chassis of any preceding clause, wherein the data repository further stores a correlation between each of the plurality of compressive sampling protocols and at least one input signal.
19. The sensor chassis of any preceding clause, wherein the processing subsytem dynamically determines the compressive sampling protocol for compressively sampling the input signal based on a stored correlation corresponding to the input signal.
20. The sensor chassis of any preceding clause, wherein the processing subsytem customizes the determined compressive sampling protocol for compressively sampling the input signal based on the remotely received parameters.

## Claims

1. A method (300) for configuring a sensor chassis (102), comprising:
remotely receiving (302) a set of parameters for compressively sampling an input signal;
dynamically determining (304) a compressive sampling protocol for compressively sampling the input signal based on the remotely received set of parameters for achieving a desired sampling performance; and
compressively sampling (306) the input signal according to the determined compressive sampling protocol.

2. The method (300) of claim 1, wherein the received set of parameters comprises an environmental datum associated with the input signal, a characteristic of the input signal, a parameter corresponding to the sensor chassis, and a criterion specifying the desired sampling performance.

3. The method (300) of any preceding claim, wherein compressively sampling the input signal according to the determined compressive sampling protocol comprises:
storing one or more instructions corresponding to the determined compressive sampling protocol on a sampling control unit; and
communicatively coupling the sampling control unit to the sensor chassis.

4. The method (300) of any preceding claim, further comprising:
monitoring (308) a sampling performance of the sensor chassis; and
alerting if the desired sampling performance is not achieved.

5. The method (300) of claim 4, further comprising customizing the determined compressive sampling protocol upon determining that the desired sampling performance is not achieved.

6. A sensor chassis (102), comprising:
a receiver (116) that receives an input signal;
a processing subsystem (214) that:
remotely receives a set of parameters for compressively sampling the input signal;
dynamically determines a compressive sampling protocol for compressively sampling the input signal based on the remotely received set of parameters for achieving a desired sampling performance; and
one or more programmable filters, each programmable filter having at least one setting, wherein a value corresponding to each of the at least one setting is adjusted according to the determined compressive sampling protocol,
wherein the sensor chassis (102) compressively samples the input signal according to the determined compressive sampling protocol.

7. The sensor chassis (102) of claim 6, further comprising a sampling control unit (128, 210), wherein the sampling control unit (128, 210) comprises at least one of a memory device, a programmable device, and a control device, and wherein the sampling control unit (128, 210) receives one or more instructions corresponding to the determined compressive sampling protocol from the processing subsystem.

8. The sensor chassis (102) of claim 6 or claim 7, wherein the processing subsystem (214) further:
monitors a sampling performance of the sensor chassis (102); and
generates an alert based on the monitored sampling performance.

9. The sensor chassis (102) of any of claims 6 to 8, further comprising a data repository (122) for storing a plurality of compressive sampling protocols and a correlation between each of the plurality of compressive sampling protocols and at least one input signal.

10. The sensor chassis (102) of any of claims 6 to 9, wherein the processing subsytem (214) dynamically determines the compressive sampling protocol for compressively sampling the input signal based on a stored correlation corresponding to the input signal.
